# EUROPEAN PATENT APPLICATION

(11) **EP 0 917 187 A2**
(43) Date of publication of application: **19.05.1999**
(21) Application number: 98120691.5
(22) Date of filing: 06.11.1998
(51) Int. Cl.: H01L 21/3213, H01L 21/768

(54) **Method of etching aluminium-based layer**

(30) Priority: 14.11.1997 US 971166
(71) Applicant: SIEMENS AKTIENGESELLSCHAFT, 80333 München (DE); International Business Machines Corporation, Armonk, N.Y. 10504 (US); KABUSHIKI KAISHA TOSHIBA, Kawasaki-shi, Kanagawa-ken 210-8572 (JP)
(72) Inventor: Spuler, Bruno, Wappingers Falls, NY 12590 (US); Grewal, Virinder, Fishkill, NY 12524 (US); Narita, Masaki, Isogo-ku, Yokohama-shi (JP); Chi-Hua, Yang, Yorktown, NY 10598 (US)
(74) Representative: HOFFMANN - EITLE

(57) **Abstract**

An Al-based metal layer (10) is formed on the semiconductor body (11) and then coated with a layer (25) of photoresist. A resist pattern is then formed in the layer (25) of photoresist by means of lithography. The resulting semiconductor substrate (21) is placed in the reaction chamber of ICP (Inductively Coupled Plasma) equipment. A mixed gas containing HCl and BCl₃ is introduced into the reaction chamber to etch the metal layer (10) using the photoresist layer (25) as a mask, thereby forming interconnect lines. The etching is effected by Cl ions or Cl active species disassociated from either HCl or BCl₃. In this etch process, the Cl ions or Cl active species react with the photoresist to thereby form a sidewall protection film (26) consisting of Al₂O₃ at sidewalls of the lines of interconnect.

## Description

The present invention relates to a method of manufacturing semiconductor devices, and more specifically to a dry etching technique for aluminum-based layers used as interconnections.

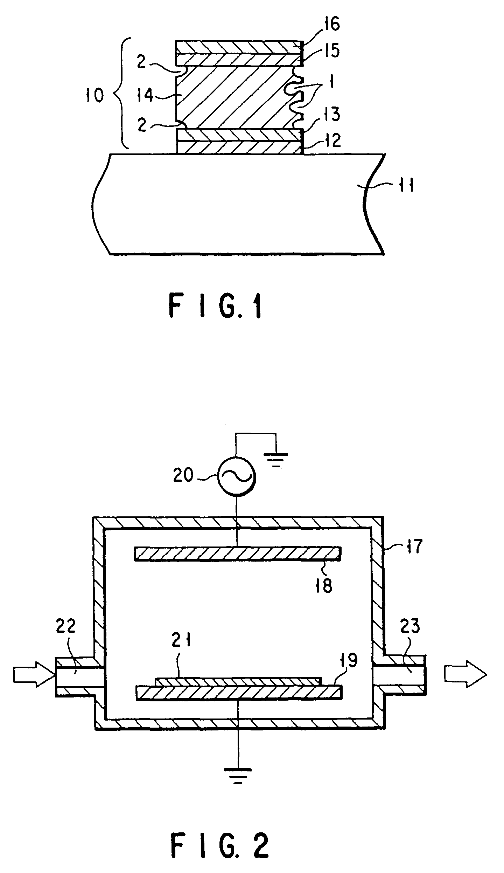

In recent years, such a multilayered interconnection structure as shown in FIG. 1 has been used that is formed by stacking an Al- or Al alloy-containing film and a metallic barrier layer in order to ensure good conductivity, contact integrity, and resistance to electromigration. The interconnect layer, indicated generally at 10, is formed on a semiconductor substrate 11 by stacking a Ti film 12, a TiN film 13, an Al- or Al alloy-containing film 14, a Ti film 15, and a TiN film 16 in this sequence. Since the Al- or Al alloy-containing film 14 is used as the base material of the interconnect line, low resistivity can be achieved. The TiN films 13 and 15 serve as a barrier to prevent aluminum in the film 14 from migrating into the semiconductor substrate 11, increasing the resistance to electromigration. The Ti film 12 reduces the resistance of contact with diffused regions in the semiconductor substrate 11, the interconnect layers, and electrodes.

This type of interconnection structure and etch (patterning) processes involved are disclosed in, for example, U.S. Patent No. 5,207,868.

FIG. 2 is a schematic illustration of a plasma reactor used in the etch processes for the interconnect layer described above. This reactor, which is of the parallel plate electrode type, has a pair of plate electrodes 18 and 19 which are opposed to each other within a reaction chamber 17. One of the electrodes, 18, is connected to a radio-frequency power source 20 to generate a plasma and attract ions, while the other electrode 19 is grounded. On the electrode 19 is placed a wafer 21 that is an object of etching. The etching is made while introducing into the chamber 17 through the inlet 22 a reactant gas which depends on a material to be etched. For example, a mixture of Cl₂ and BCl₃ gases is used in etching Al- or Al alloy-containing interconnections. The mixed gas after reaction is exhausted through the outlet 23.

In general, a Cl₂ gas is used as a main gas for the metal etch process. The etch process requires a high etch rate and high selectivity to metal, photoresist, and oxide. The high-density Cl₂ gas used in this process fulfills the performance required with the etching of Al or Al alloys, meeting the requirement of high etch rate. In the dry etching process for Al or Al alloys, however, the etching using the Cl₂ gas in the equipment using such a high-density plasma source as described above produces excessive electrically neutral active species, which cause etching of sidewalls of metal layers used as interconnections and pattern defects.

In order to avoid the etching of sidewalls of metal layers and pattern detects due to isotropic etching of Al or Al alloys, a technique for forming sidewall protection films on sidewalls of Al - Si patterns is disclosed in, for example, U.S. Patent No. 5,221,430. As the sidewall protection films, use is made of C-Clx, C-Clx-Iy, or the like. In the absence of sufficient sidewall polymer such as C-Clx, however, voids 1 and undercuts 2 are formed by Cl₂ used as the etching gas or chlorine radicals disassociated by plasma (see FIG. 1). In addition, the sidewall polymer is detrimental to Al or Al-alloy film (e.g., Al-Cu film) and, after the termination of the etching, must be removed completely to avoid corrosion of interconnect layers. Being organic substances, C-Clx and C-Clx-Iy are difficult to be stripped off interconnect layers made of Al or Al alloys. The process of removing the sidewall polymer will therefore increase manufacturing cost and complicate post-treatment.

As described above, the conventional process of etching (patterning) an Al-based interconnect layer using a Cl₂ gas, though providing high etch rate and high etch selectivity, causes excessive electrically neutral active species to be produced, resulting in sidewall etching and pattern defects. When a sidewall polymer is formed to avoid such a problem due to isotropic etching, voids and undercuts are formed in case where the resulting sidewall polymer is not sufficient. In addition, the sidewall polymer must be removed completely after the termination of the etch process, which results in complicated post-treatment and increased manufacturing cost.

It is therefore an object of the present invention to provide a method of manufacturing a semiconductor device which suppresses interconnect layer sidewall etching and pattern defects with high etch rate and high etch selectivity maintained.

It is another object of the present invention to provide a method of manufacturing a semiconductor device which suppresses the formation of voids and undercuts at sidewalls of interconnect layers.

It is still another object of the present invention to provide a method of manufacturing a semiconductor device which ensures simplified manufacturing process and reduced manufacturing cost, and provides high throughput.

The objects are attained by a method of manufacturing a semiconductor device comprising the steps of: forming an Al-containing metal layer on the major surface of a semiconductor body; coat the metal layer with a layer of photoresist and then forming a resist pattern in the photoresist layer by means of lithography; and placing the resulting semiconductor body in the reaction chamber of ICP (Inductively Coupled Plasma) equipment, introducing a mixed gas containing HCl and BCl₃ into the reaction chamber, and etching the metal layer using the photoresist layer formed with the resist pattern as a mask.

According to such a manufacturing method, the metal layer is etched in the ICP equipment using a mixed gas containing HCl and BCl₃. Thus, the production of excessive electrically neutral active species can be suppressed, and moreover, since the etching is effected by Cl ions disassociated from either HCl or BCl₃, sidewall etching and pattern defects due to isotropic etching resulting from the use of Cl₂ can be suppressed. The etching based on Cl ions is high in etch rate, ensuring high etch selectivity to the metal layer, photoresist, and oxide. In etching the metal layer, Cl ions react with the photoresist layer used as a mask to form a sidewall protective film at sidewalls of the interconnect layer. For this reason, the formation of voids and undercuts can be suppressed.

The objects are attained by a method of manufacturing a semiconductor device comprising the steps of: forming a first metal layer containing Al as a base material on the major surface of a semiconductor body; coat the first metal layer with a first layer of photoresist and then forming a resist pattern in the photoresist layer by means of lithography; placing the resulting semiconductor body in the reaction chamber of ICP (Inductively Coupled Plasma) equipment, introducing a mixed gas containing HCl and BCl₃ into the reaction chamber, and etching the first metal layer using the first photoresist layer as a mask; forming an insulation film on the first metal layer; forming contact holes in a portion of the insulation film; forming a second metal layer on the insulation film, the second metal layer being electrically connected with the first metal layer through the contact holes; coating the second metal layer with a second layer of photoresist and forming a resist pattern in the second layer of photoresist by means of lithography; and etching the second metal layer using the second layer of photoresist formed with the resist pattern as a mask.

According to such a manufacturing method, the first metal layer is etched in the ICP equipment using a mixed gas containing HCl and BCl₃. Thus, the production of excessive electrically neutral active species can be suppressed, and moreover, since the etching is effected by Cl ions disassociated from either HCl or BCl₃, sidewall etching and pattern defects due to isotropic etching by Cl active species resulting from the use of Cl₂ can be suppressed. The etching based on Cl ions or Cl active species is high in etch rate, ensuring high etch selectivity to the first metal layer, photoresist layer, and oxide. In etching the first metal layer, the Cl ions react with the photoresist layer used as a mask to form a sidewall protective film at sidewalls of the interconnect layer. For this reason, the formation of voids and undercuts can be suppressed. The second metal layer may be etched using conventional etching techniques based on a Cl₂ gas because it is allowed to be greater in line width and line spacing than the first metal layer,

This summary of the invention does not necessarily describe all necessary features so that the invention may also be a sub-combination of these described features.

This invention can be more fully understood from the following detailed description when taken in conjunction with the accompanying drawings, in which:
FIG. 1 is a cross-sectional view of a multilayered interconnection structure in which a film of Al or an Al alloy and a metallic barrier layer are stacked, which is useful in explaining a conventional semiconductor device manufacturing process;
FIG. 2 is a schematic illustration, in section, of conventional plasma etching equipment used in the interconnection etching process;
FIG. 3 is a flowchart for the interconnection etching (patterning) process in accordance with a semiconductor device manufacturing method of the present invention;
FIG. 4 is a schematic illustration, in section, of etching equipment (IPC) used in the process of etching the first-level interconnection layer in FIG. 3;
FIG. 5 is a cross-sectional view of an interconnect line formed by the process of etching the first-level interconnect layer shown in FIG. 3;
FIG. 6 is an etching condition table indicating collectively process parameters used in the first-level interconnect layer etch process;
FIG. 7A is a photograph of interconnect lines formed under the etching conditions shown in FIG. 6, particularly of the pattern of the central portion of a wafer;
FIG. 7B is a photograph of the interconnect lines formed under the etching conditions shown in FIG. 6, particularly of the pattern of the periphery of the wafer;
FIG. 8A is a diagram for use in explanation of the Auger spectrum of a sidewall polymer at sidewalls of interconnect layers formed by etching equipment, which shows the u-Auger spectrum for the conventional etching process; and
FIG. 8B is a diagram for use in explanation of the Auger spectrum of a sidewall polymer at sidewalls of interconnect layers formed by etching equipment, which shows the u-Auger spectrum for the etching process of the present invention.

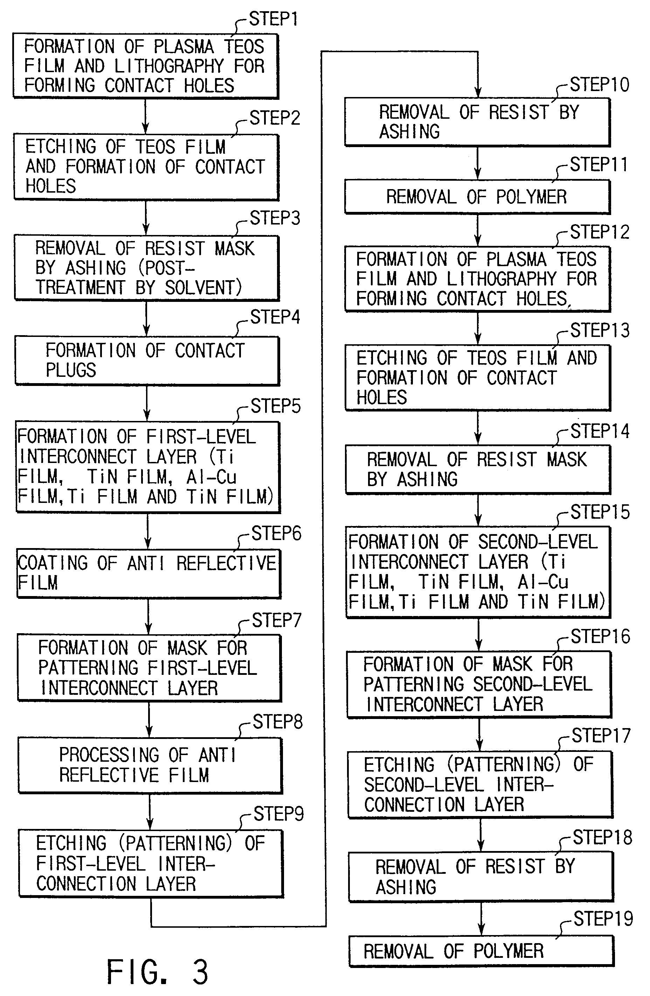

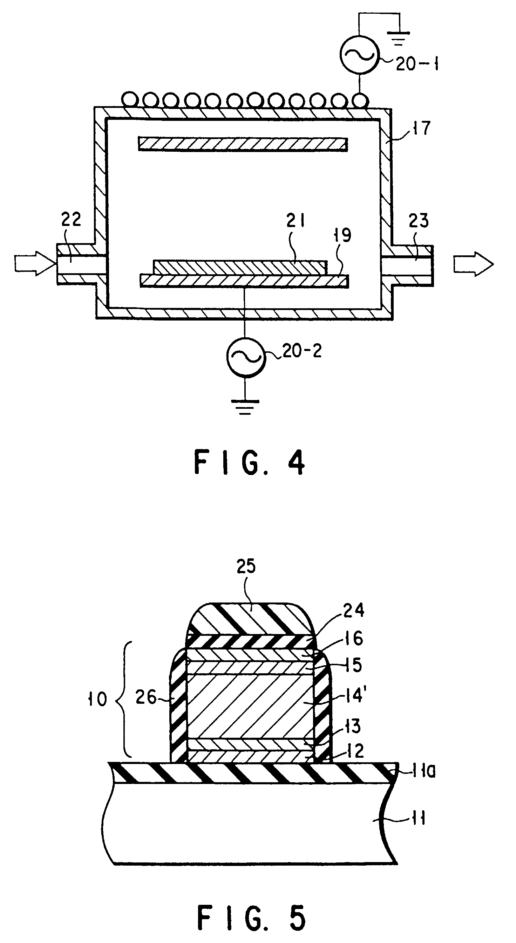

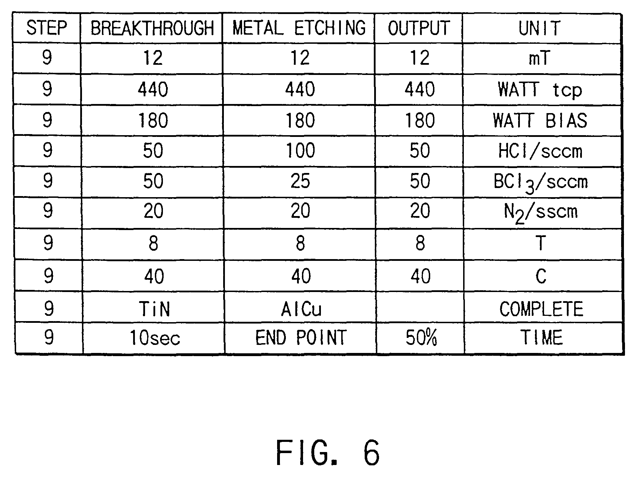

In FIG. 3, there is illustrated a flowchart for the interconnection etching (patterning) process in accordance with a semiconductor device manufacturing method of the present invention. In FIG. 4 there is schematically illustrated, in section, etching equipment (ICP: Inductively Coupled Plasma equipment) used in the process of etching the first-level interconnect layer in FIG. 3. In FIG. 5 there is illustrated, in cross section, an interconnect layer or line formed by the process of etching the first-level interconnection layer shown in FIG. 3. In FIG. 6 there are illustrated collectively process parameters used in the first-level interconnection layer etching process.

The present invention is directed to a process of patterning metal interconnections in the manufacture of a semiconductor device, i.e., the process of etching multilevel layers containing an aluminum - copper (Al-Cu) film without using a chlorine (Cl₂) gas to form interconnections or wirings. In particular, this process has been developed for 256- or 64-MB DRAMs that require the etching of metal interconnections in the 0.25 µm or 0.35 µm design rule. It should however be noted that the present invention is also applicable to the process of etching or patterning of metal films in general in the manufacture of other semiconductor devices than DRAMS.

Next, a process of manufacturing a semiconductor device in accordance with the present invention will be described in terms of a process of etching interconnect layers, particularly a process of patterning a first-level interconnect layer and a second-level interconnect layer in 256-MB DRAMs.

As shown in the flowchart of FIG. 3, a plasma TEOS (SiO₂) film is deposited on the surface of a semiconductor substrate (semiconductor body) to a thickness of about 4000Å after the formation of bit lines (W interconnections). A lithography process is then carried out for the formation of contact holes to make contact between the bit lines and a first layer of interconnections to be formed on the TEOS film (STEP 1).

The TEOS film is then subjected to an etch process to form contact holes therein (STEP 2).

After the formation of the contact holes, the resist mask is removed by means of ashing. At this point, a post-treatment may be carried out using a solution in order to remove the resist completely (STEP 3).

In the subsequent step, a film of tungsten (W) is deposited onto the TEOS film by means of CVD (Chemical Vapor Deposition). The resulting film of tungsten is then removed from portions other than the contact holes by means of CMP, thereby forming contact plugs (STEP 4).

A first-level interconnect layer is then formed. To this end, in the first place, a film of titanium (Ti) of 200Å thickness, a film of titanium nitride (TiN) of 100Å thickness, a film of Al-Cu (0.5% Cu) of 2000 to 3000Å thickness, a film of Ti of 50Å thickness, and a film of TiN of 400Å thickness are deposited in this sequence onto the semiconductor substrate by means of sputtering (STEP 5). Thus, the first-level interconnect layer of the laminated type is formed.

After the formation of the first-level interconnect layer, the top TiN film is coated with an anti reflective film of an organic material so as to prevent adverse reflection from the surface of the TiN film in the course of lithography for processing the interconnect layer (STEP 6). The thickness of the anti reflective film is of the order of 900Å.

After that, a lithography process is carried out to form a mask used for patterning the first-level interconnect layer over the anti reflective film (STEP 7). The thickness of a photoresist used for this lithography is of the order of 8500Å. The photoresist thickness will be reduced to about 6500Å at the termination of etching.

Prior to patterning of the first-level interconnect layer, the anti reflective film is processed first (STEP 8). In general, oxide etching equipment is used to process the anti reflective film. Alternatively, Al etching equipment may be used.

After that anti reflective film processing, the first-level interconnect layer is etched (STEP 9). This etching of the interconnect layer is carried out by three substeps. The first substep is performed to etch the TiN and Ti films above the Al - Cu film. Note however that the first substep need not necessarily be performed until the TiN and Ti films are etched away completely. The second substep is then performed to etch the Al - Cu film. The third substep is performed to etch the Ti and TiN films below the Al - Cu film. This etch step is performed until the underlying oxide formed on the substrate surface is exposed, i.e., the patterning of the interconnect layer is completed.

To etch the Al - Cu film, the TCP equipment made by Research company, TCP LAM 9600, was used, which is schematically illustrated in FIG. 4. The TCP equipment is equipped with two RF power sources 20-1 and 20-2 in a reaction chamber 17. The RF power source 20-1 is adapted to generate a plasma, whereas the RF power source 20-2 attracts ions. The etching process was performed under operating conditions of a gas pressure of 12 mTorr, an electric power of 440W of the upper RF power source 20-1, an electric power of 180W of the lower RF power source 20-2, an HCl flow rate of 100 sccm, a He pressure of 8 Torr on the surface of a wafer 21, and a reaction temperature of 40°C.

In the second step of STEP 9, a Cl-ion containing mixed gas is used instead of Cl₂. An etchant is furnished from a Cl-containing gas, i.e., HCl and BCl₃, thereby etching the Al - Cu film. In other words, this etching is effected by Cl ions disassociated from either HCl or BCl₃. This etching has high selectivity to photoresist, so that sidewalls are little etched. And excessive Cl active species are trapped by H ions produced in plasma to form HCl. As a result, the activity of Cl is lowered and sidewise etching of Al does not take place. A sidewall protection film consisting of Al₂O₃ is formed at sidewalls of the Al - Cu film to make up such a structure as shown in FIG. 5. As shown in FIG. 5, a TEOS film 11a is formed on the surface of a semiconductor substrate (semiconductor body) 11, and a first-level interconnect layer 10 is then formed over the TEOS film 11a. The interconnect layer 10 is formed from a stack of a Ti film 12, a TiN film 13, an Al-Cu film 14', a Ti film 15, and a TiN film 16. On the topmost TiN film 16 is formed an anti reflective film 14, which, in turn, is formed on top with a layer 25 of photoresist. On the sidewalls of the interconnect layer 10 is formed a sidewall protection film 26 consisting of a polymer, which has high corrosion resistance, protects the Al - Cu film 14' from isotropic etching, and suppresses the formation of voids and undercuts. Thus, the formation of voids and undercuts can be suppressed with high etch rate and high selectivity to photoresist maintained. As a result, high-precision processing is made possible.

After the first-level interconnect layer 10 has been patterned, the photoresist layer 25 is removed by ashing within a given period of time (STEP 10). This step is to prevent corrosion due to residual chlorine.

After the ashing removal of the resist layer 25, a solution process is carried out to remove the polymer 26 consisting of reaction by-products (STEP 11). C-Clx and C-Clx-Iy formed by the conventional process are difficult to be stripped off the Al-Cu film 14 because they are organic materials. In contrast, Al₂O₃ is easy to be stripped off the Al - Cu film 14' because it is a metallic material. Polar solvent processing allows the Al₂O₃ to be stripped easily.

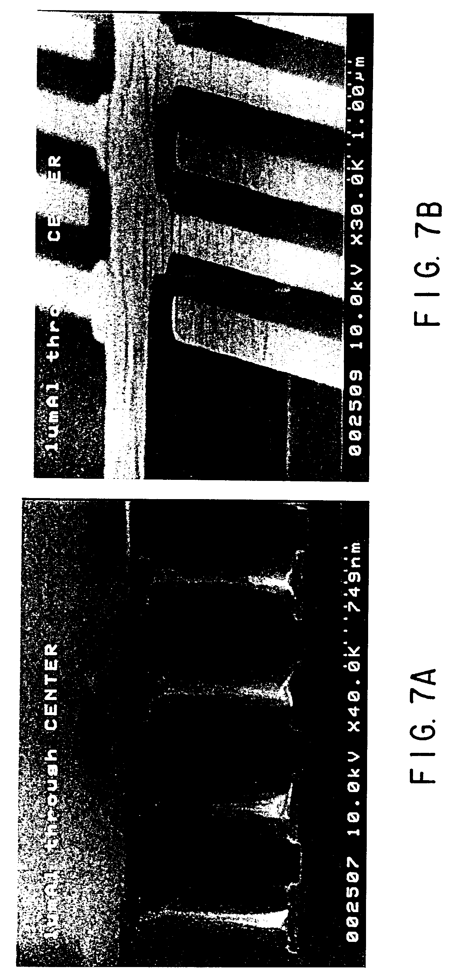

FIGS. 7A and 7B are photographs of first-level interconnect layers (lines) formed by the inventive etching process described above. Specifically, FIG. 7A shows the pattern of the central portion of a wafer, whereas FIG. 7B shows the pattern of the periphery of that wafer. In this instance, the thickness of the interconnect layers was set to 1.0 µm and the layer (line) spacing was set to 0.25 µm. From these photographs it will be appreciated that the sidewall etching and pattern defects were suppressed satisfactorily. In addition, voids and undercuts were not observed.

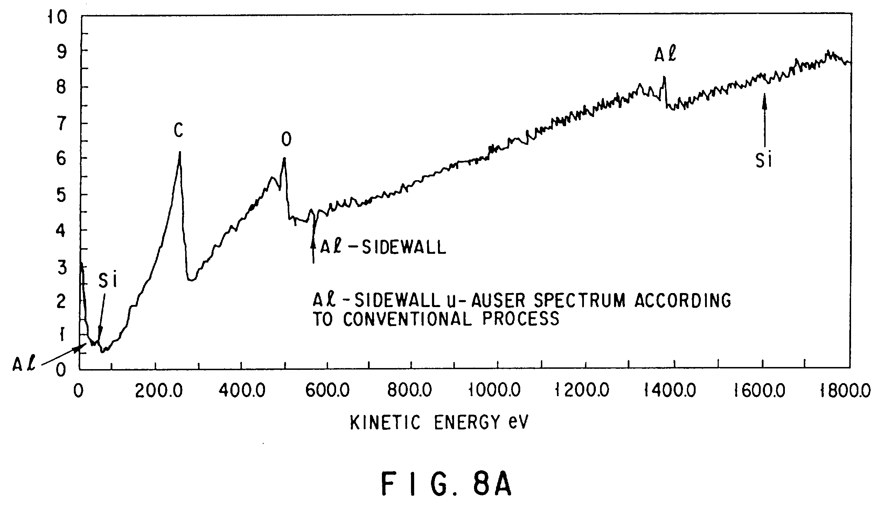

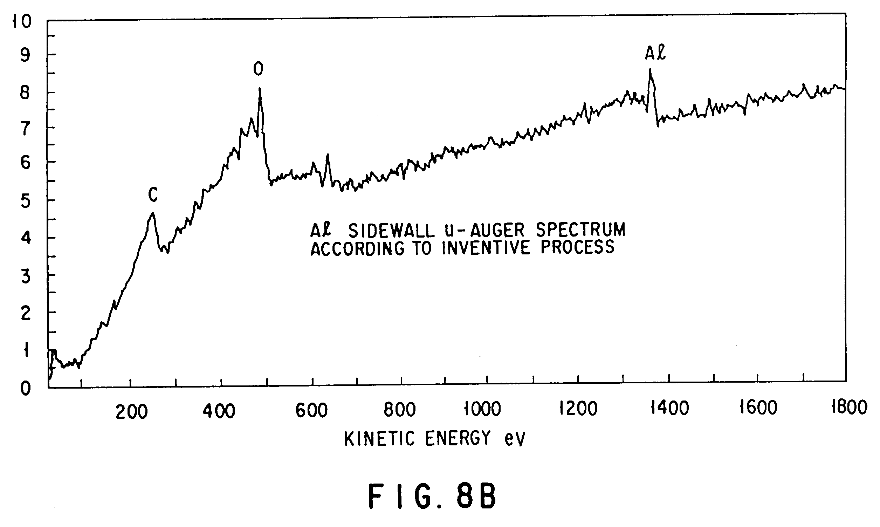

FIGS. 8A and 8B are graphs illustrating the Auger spectra of Al sidewall polymers of interconnect layers. Specifically, FIG. 8A illustrates a u-Auger spectrum in the conventional etch process, and FIG. 8B illustrates a u-Auger spectrum in the etch process of the present invention. As is evident from comparison between these graphs, the peak of C is lowered in the process of the present invention, indicating that, unlike the conventional polymers, the polymers of the present invention contain little C and C - Cl. Thus, the corrosion of and difficulty of stripping the interconnect layers can be alleviated.

After the polymer 26 is removed to thereby complete the first-level Al-Cu interconnect layer, a plasma TEOS (SiO₂) film is deposited to a thickness of 6000Å. In the subsequent step, a lithography process is carried out to form contact holes in the TEOS film for making contact with a second-level interconnect layer to be formed on that film (STEP 12).

After the lithography process, the plasma TEOS film is etched to form the contact holes (STEP 13). During this etch process, the topmost TiN film 16 of the interconnect layer 10 is used as an etch stopper so as not to etch the first-level interconnect layer. As such, in this etch process, it is preferable that the selectivity to TiN be high.

After the contact holes are formed, the resist layer used as a mask for forming the contact holes is removed by ashing (STEP 14).

After the photoresist layer is removed, the second-level interconnect layer is formed. The second-level interconnect layer is formed by means of sputtering in such a way that a Ti film of 200Å thickness, a TiN film of 200Å thickness, an Al-Cu film (0.5% Cu) of 1 µm thickness and a TiN film of 400Å thickness are evaporated in sequence (STEP 15). That is, the second-level interconnect layer has a multilayer structure.

After that, a lithography process is performed to form a mask for patterning the second-level interconnect layer (STEP 16).

Using the mask, the second-level interconnect layer is selectively etched to form an interconnect pattern (STEP 17). In patterning the second-level interconnect layer, the line width and the line spacing can be greater than with the first-level interconnect layer. The conventional etching techniques can therefore be used.

After the second-level interconnect layer is etched, the photoresist layer is removed by ashing within a fixed period of time (STEP 18). This is to prevent corrosion due to residual chlorine.

After the removal of the photoresist layer, a solution process is carried out to remove polymers made of reaction by-products (STEP 19).

Thus, the patterning of two layers of interconnections is completed.

The inventors examined sidewalls after the patterning of Al - Cu films in the 0.25- and 0.35-µm design rules. In either case, neither voids nor undercuts were observed. And it was confirmed that the adequate patterning of an Al-Cu film of 1 µm thickness is also possible. This allows etching of high aspect ratio.

Although the preferred embodiment has been described and disclosed, the present invention may be practiced or embodied in still other ways without departing the scope and spirit thereof. For example, although the embodiment has been described in terms of Al - Cu as an Al-based material, use may be made of another Al alloy such as Al - Si. Alternatively, use may be made of Al itself, which will provide similar effects and advantages to Al alloys'. Although Ti and TiN are used as etch and migration stoppers, a multilayer structure of a metal layer, such as tungsten, and an Al or Al alloy film may be used. Although the patterning of a five-level interconnect layer was described, the inventive process can, of course, be applied to a trilevel interconnect layer in which an Al alloy film is sandwiched between two layers of TiN. That is, the inventive process can be applied to interconnections of any level as long as an Al-based material is contained.

As described above, to etch an Al or Al alloy film in interconnect layers, the present invention uses ICP equipment and a gaseous mixture of HCl and BCl₃ as an etching gas. Unlike the parallel plate electrode type of plasma etching equipment ECR (Electron Cyclotron Resonance) in which a single RF power source is provided for both the generation of plasma and attraction of ions, the ICP equipment is equipped with two RF power sources: one for the generation of plasma and one for the attraction of ions. For this reason, unlike the conventional equipment, the ICP equipment allows an Al or Al-alloy film to be etched using a gaseous mixture of HCl and BCl₃. The etch process in the ICP equipment is effected by Cl ions and Cl active species disassociated from either HCl or BCl₃, not Cl₂. At this point, Cl ions react with a photoresist layer used as a mask, producing Al₂O₃ at sidewalls of the Al or Al-alloy film. The Al₂O₃ stabilizes and protects the sidewalls of Al or Al-alloy films. Thereby, sidewall etching and pattern defects can be suppressed with high etch rate and high selectivity to photoresist and oxide. Since the sidewalls of Al or Al-alloy films are protected by Al₂O₃ during etch process, the formation of voids and undercuts at sidewalls of interconnect layers can be suppressed, the manufacturing process is simplified, manufacturing cost is reduced, and a semiconductor device manufacturing method with high throughput is obtained.

As described above, according to the present invention, a semiconductor device manufacturing method is provided which allows sidewall etching and pattern defects to be suppressed while maintaining high etch rate and high etch selectivity.

Moreover, a semiconductor device manufacturing method is provided which allows the formation of voids and undercuts formed at sidewalls of interconnect layers to be suppressed.

Furthermore, a manufacturing method of high-precision semiconductor devices is provided which allows the simplification of the manufacturing process and a reduction in manufacturing cost.

## Claims

1. A method of manufacturing a semiconductor device characterized by comprising the steps of:
forming an Al-containing metal layer (10) on the major surface of a semiconductor body (11);
coat the metal layer (10) with a layer (25) of photoresist and then forming a resist pattern in the photoresist layer (25) by means of lithography; and
placing the resulting semiconductor body (21) in the reaction chamber (17) of ICP (Inductively Coupled Plasma) equipment, introducing a mixed gas containing HCl and BCl₃ into the reaction chamber (17), and etching the metal layer (10) using the photoresist layer (25) formed with the resist pattern as a mask.

2. The method according to claim 1, characterized in that the metal layer (10) includes an Al or Al-alloy film (14') and a metal barrier film (12, 13, 15, 16).

3. The method according to claim 1, characterized in that the metal layer (10) is formed by evaporating a Ti film (12), a TiN film (13), an Al alloy film (14'), a Ti film (15), and a TiN film (16) in sequence onto the major surface of the semiconductor body (11) by means of sputtering.

4. The method according to claim 3, characterized in that the step (STEP 9) of etching the metal layer (10) includes a first substep of etching the Ti film (15) and the TiN film (16) above the Al alloy film (14'), a second substep of etching the Al alloy film (14') by means of the mixed gas containing HCl and BCl₃, and a third substep of etching the Ti film (12) and the TiN film (13) below the Al alloy film (14') until the major surface of the semiconductor body (10) is reached, each of the first, second and third substeps being carried out using the layer (25) of photoresist as a mask.

5. The method according to claim 2, characterized in that the Al alloy film (14') is made of an Al - Cu alloy.

6. The method according to claim 1, characterized in that the etching of the metal layer (10) is effected by Cl ions being disassociated from at least one of the HCl gas and the BCl₃ gas in the reaction chamber (17) of the ICP equipment and the Cl ions or Cl active species reacting with the metal layer (10).

7. The method according to claim 6, characterized in that a polymer-based sidewall protection film (26) is created at sidewalls of the metal layer (10) by a reaction of the Cl ions or the Cl active species with the layer (25) of photoresist.

8. The method according to claim 7, characterized in that the sidewall protection film (26) protects the sidewalls of the metal layer (10) from isotropic etching during the step of etching the metal layer (10).

9. The method according to claim 7, characterized in that the sidewall protection film (26) is made of Al₂O₃.

10. The method according to claim 1, characterized in that the ICP equipment is equipped with a first radio-frequency power source (20-1) for generating plasmas and a second radio-frequency power source (20-2) for attracting ions.

11. The method according to claim 1, characterized by further comprising the step (STEP 1) of, prior to the step (STEP 5) of forming the metal layer (10), forming an insulation film (11a) on the major surface of the semiconductor body (11).

12. The method according to claim 11, characterized in that the insulation film (11a) is a plasma TEOS (Tetraethoxysilane) film.

13. The method according to claim 11, characterized by further comprising the step (STEP 1) of forming contact holes in the insulation film (11a) for electrically connecting the metal layer (10) with a conducting layer formed in the semiconductor body (11).

14. The method according to claim 13, characterized by further comprising the step of (STEP 4), prior to the step (STEP 5) of forming the metal layer (10), filling the contact holes with contact plugs.

15. The method according to claim 14, characterized in that the step (STEP 4) of filling the contact holes with contact plugs includes a substep of forming a film of a material for the contact plugs on the insulation film (11a) and into the contact holes by means of CVD and a substep of removing that film formed on the insulation film (11a) by means of CMP.

16. The method according to claim 1, characterized by further comprising the step (STEP 6) of, after the step (STEP 5) of forming the metal layer (10), forming an anti reflective film (24) consisting of an organic material on the metal layer (10), the layer (25) of photoresist being formed on the anti reflective film (24).

17. The method according to claim 1, characterized by further comprising the step (STEP 10) of, after the step (STEP 9) of etching the metal layer (10), removing the layer (25) of photoresist by means of ashing within a given period of time.

18. The method according to claim 17, characterized by further comprising the step (STEP 10) of, after the step (STEP 10) of removing the layer (25) of photoresist, performing a solution process to remove the polymer created at sidewalls of the Al alloy film (14') by causing the Cl ions to react with the layer of photoresist.

19. A method of manufacturing a semiconductor device characterized by comprising the steps of:
forming a first insulation film (11a) on the major surface of a semiconductor body (11);
forming a first metal layer (10) containing Al as a base material on the first insulation film (11a);
coat the first metal layer with a first layer of photoresist and then forming a resist pattern in the photoresist layer by means of lithography;
placing the resulting semiconductor body (11) in the reaction chamber (17) of ICP (Inductively Coupled Plasma) equipment, introducing a mixed gas containing HCl and BCl₃ into the reaction chamber (17), and etching the first metal layer (10) using the first photoresist layer (25) as a mask;
forming a second insulation film on the first metal layer;
forming contact holes in a portion of the second insulation film;
forming a second metal layer on the second insulation film, the second metal layer being electrically connected with the first metal layer through the contact holes;
coating the second metal layer with a second layer of photoresist and forming a resist pattern in the second layer of photoresist by means of lithography; and
etching the second metal layer using the second layer of photoresist formed with the resist pattern as a mask.

20. The method according to claim 19, characterized in that the second insulation film is a plasma TEOS film.

21. The method according to claim 19, characterized in that the second metal layer is formed by evaporating a Ti film, a TiN film, an Al alloy film, a Ti film, and a TiN film in sequence onto the second insulation film by means of sputtering.

22. The method according to claim 19, characterized by further comprising the step (STEP 18) of, after the step (STEP 17) of etching the second metal layer, removing the second layer of photoresist by means of ashing within a given period of time.
